# EUROPEAN PATENT APPLICATION

(11) **EP 2 086 293 A1**
(43) Date of publication of application: **05.08.2009**
(21) Application number: 08254167.3
(22) Date of filing: 29.12.2008
(51) Int. Cl.: H05K 1/02, H05K 1/03

(54) **Printed circuit board**

(30) Priority: 24.01.2008 CN 200810300203
(71) Applicant: Hon Hai Precision Industry Co., Ltd., Tu-cheng City, Taipei Hsien (TW)
(72) Inventor: Lin, Yu-Hsu, Santa Clara, CA 95050 (US); Wu, Jeng-Da, Tu-cheng City Taipei Hsien Taiwan (CN); Chao, Chih-Hang, Tu-cheng City Taipei Hsien Taiwan (CN)
(74) Representative: Craven, Ian

(57) **Abstract**

A printed circuit board includes a base (40) and a signal trace (47) formed on the base. The signal trace includes a plurality of straight line segments (C1,C2,C3,C4) parallel to the first fibers (41). The signal trace is formed on the base in such a manner that the line segments partially superpose the first fibers (41) and partly superpose gap between adjacent first fibers.

## Description

### 1. Technical Field

The present invention relates to a printed circuit board having high signal transmission quality.

### 2. Description of Related Art

A typical printed circuit board (PCB) includes a base, resin, and copper foil. The base for the PCB is usually constructed from woven glass fiber cloth. During the PCB manufacturing process, the base is treated by passing it through a dip pan containing resin. The treated base is then passed through a set of squeeze rollers into a drying oven to cure. After the PCB has been cured, the base is cut into a desired size and copper foil is applied to one or both sides of the base, typically by electrodeposition. The copper foil is etched to form different signal traces on the PCB.

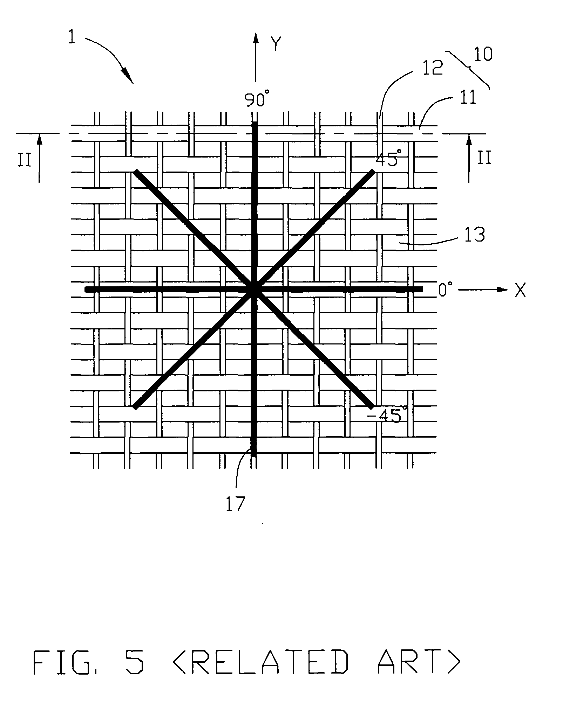

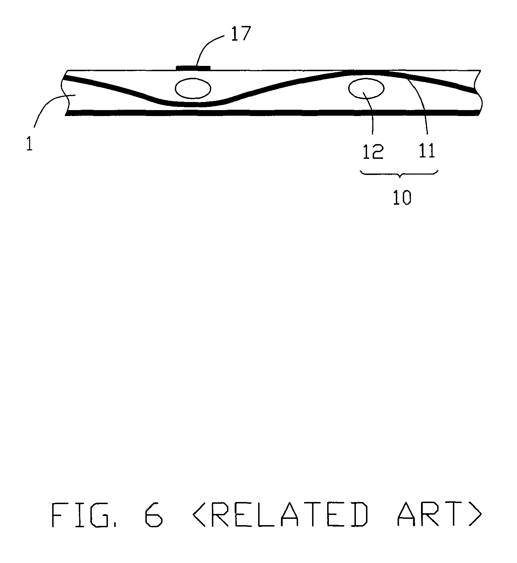

Referring to FIGS. 5 and 6, a PCB 1 includes a base 10 which includes a plurality of first fibers 11 and a plurality of second fibers 12. The PCB 1 defines an X-axis extending in a horizontal direction and a Y-axis perpendicular to the X-axis. The first fibers 11 are aligned in the X-axis direction and interlaced with the second fibers 12 aligned in the Y-axis direction. Resin is impregnated in gaps 13 between the fibers 11, 12. Each straight line segment of a signal trace 17 is arranged on the PCB 1 at an angle of 0, 45, 90, or -45 degrees relative to the X-axis. Some line segments cross the fibers 11, 12, for example, the line segments arranged at angles of 45 and -45 degrees shown in FIG. 5. Some line segments of signal traces coincide with the fibers 11, 12, for example, the line segments arranged at angles of 0 and 90 degrees shown in FIG. 5. There is a delay between signals on different signal traces.

Therefore, a PCB minimizing signal delay time on signal traces is desired to overcome the above-described shortcomings.

### SUMMARY

A printed circuit board includes a base and a signal trace formed on the base. The signal trace includes a plurality of straight line segments parallel to the first fibers. The signal traces are formed on the base such that the line segments of the signal trace partially superpose the first fibers and partially superpose gaps between two adjacent first fibers.

Other advantages and novel features will be drawn from the following detailed description of embodiments with attached drawings, in which:

### BRIEF DESCRIPTION OF THE DRAWINGS

FIG. 1 is a schematic view of a first embodiment of a PCB;

FIG. 2 is a schematic view of a second embodiment of a PCB, the PCB including a plurality of parallel fibers each with a width P' and a signal trace having two line segments separated by a distance X away from each other;

FIG. 3 is a schematic view of the PCB of FIG.2 when X is equal to P'/2;

FIG. 4 is a schematic view of a third embodiment of a PCB;

FIG. 5 is a schematic view of a typical PCB; and

FIG. 6 is a cross-sectional view of the typical PCB of FIG. 5 taken along line II-II.

### DETAILED DESCRIPTION OF THE EMBODIMENTS

Referring to FIGS. 5 and 6, because the fibers 11, 12 and the resin have different dielectric constants, impedances of different signal traces 1 7 vary over a large range according to the locations and the angles of the line segments of the signal traces 1 7 relative to the base 10. In a PCB, if the impedances of different signal traces vary greatly, delay time of signals on different signal traces will be very different.

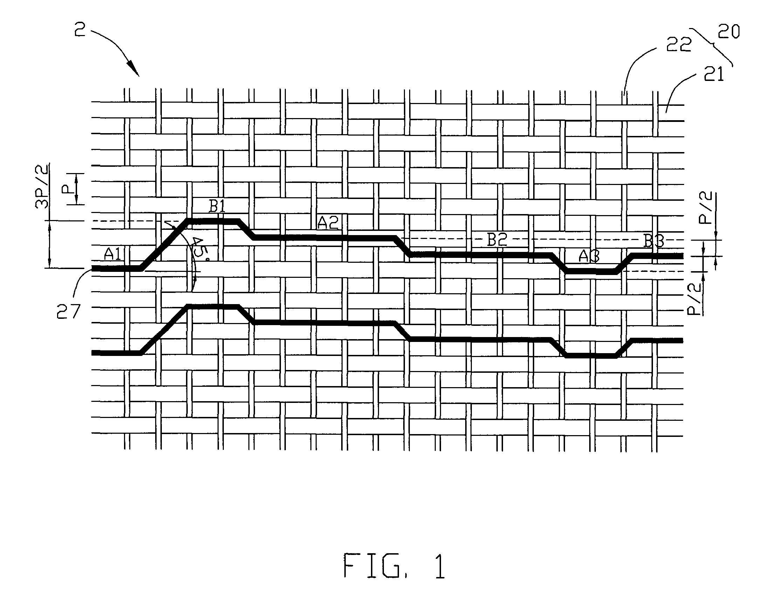

Referring to FIG. 1, a first embodiment of a PCB 2 includes a base 20 comprising a plurality of parallel first fibers 21 and a plurality of parallel second fibers 22 perpendicular to the plurality of first fibers 21. Two signal traces 27 are formed on the PCB 2. Each signal trace 27 includes a plurality of parallel line segments A1, B1, A2, B2, A3, and B3 connected end to end by diagonal line segments (not labeled) oriented at an angle of 45 or -45 degrees from the plurality of parallel line segments. A length of the line segment A1 is substantially equal to a length of the line segment B1. A length of the line segment A2 is substantially equal to a length of the line segment B2. A length of the line segment A3 is substantially equal to a length of the line segment B3. A shortest distance between the centerlines of two adjacent first fibers 21 is P. A shortest distance between the centerlines of the line segments A1, B1 is 3P/2. A shortest distance between the centerlines of the line segments B1, A2 is P/2. A shortest distance between the centerlines of the line segments A2, B2 is P/2. A shortest distance between the centerlines of the line segments B2, A3 is P/2. A shortest distance between the centerlines of the line segments A3, B3 is P/2. The two signal traces 27 partially superpose the first fibers 21 and partially superpose the gap between adjacent first fibers 21. As a result, there is little variance between the impedances of the two signal traces 27 and delay time of signals on the two signal traces 27 is minimized, thus ensuring signal transmission quality.

In the first embodiment, a shortest distance between two adjacent line segments of the signal traces 27 is substantially equal to N*P/2, wherein N is an odd number. Any one of the line segments of each signal trace 27 can be defined as a reference line segment. A first set of line segments is formed a shortest distance of M*P away from the reference line segment, where M is an integer. A second set of line segments is formed a shortest distance of R*P/2 away from the reference line segment, where R is an odd number. A length of the first set of line segments is substantially equal to a length of the second set of the line segments. Thus, a length of one of the line segments of the signal traces 27 may be substantially equal to a length of the adjacent line segments at both ends of the one of the line segments. In other words, if the first set of line segments superposes the first fibers 21, the second set of line segments superposes gaps between adjacent first fibers 21. Thus the signal trace 27 partially superposes the first fibers 21 and partially superposes gaps between adjacent first fibers 21.

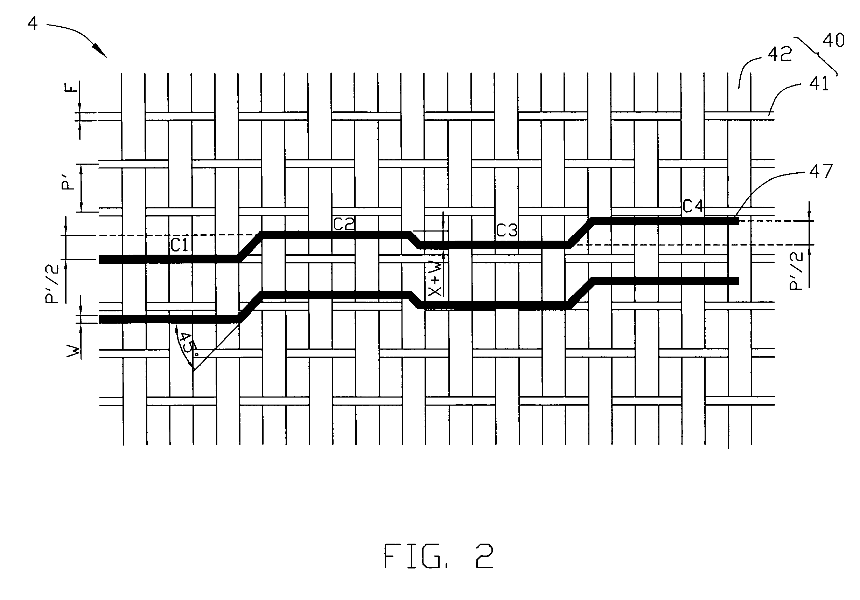

Referring to FIG. 2, a second embodiment of a PCB 4 includes a base 40 comprising a plurality of parallel first fibers 41 and a plurality of parallel second fibers 42 perpendicular to the plurality of first fibers 41. Two signal traces 47 are formed on the PCB 4. Each signal trace 47 each includes a plurality of parallel line segments C1, C2, C3, and C4 connected end to end by diagonal line segments (not labeled) oriented at an angle of 45 or -45 degrees from the plurality of parallel line segments. A length of the line segment C1 is substantially equal to a length of the line segment C2. A length of the line segment C3 is substantially equal to a length of the line segment C4. A shortest distance between the centerlines of two adjacent first fibers 41 is P'. A width of the first fiber 41 is F. A width of the signal trace 47 is W. A shortest distance between the centerlines of the line segments C1, C2 is P'/2. A shortest distance between the centerlines of the line segments C3, C2 is X. A shortest distance between centerlines of the line segments C4, C3 is P'/2. A shortest distance between an upper edge of the line segment C1 and a lower edge of the line segment C3 is P'/2-W-X, and substantially equal to a shortest distance between the upper edge of the line segment C2 and the lower edge of the line segment C4. A shortest distance between a lower edge of the line segment C2 and an upper edge of the line segment C3 is X-W. A shortest distance between a lower edge of the line segment C1 and an upper edge of the line segment C4 is P'+W-X.

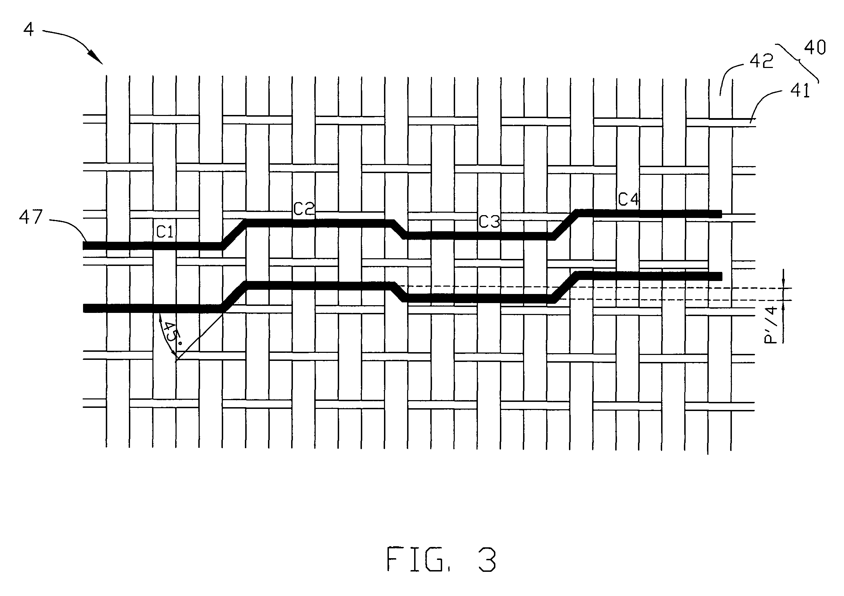

If the plurality of first fibers 41 are thin, the inequalities: P'/2-W-X<F, X-W<F, and P'+W-X>P'-F are satisfied, which means P' satisfies: 2(W+F)<P'<4(W+F), enabling the signal trace 47 to be partially superposing the fibers 41 and partially superposing gaps between two adjacent first fibers 41. If a shortest distance between centerlines of the line segments C2, C4 is substantially equal to the shortest distance between the centerlines of the line segments C2, C3, the equality: X-W=P'/2-W-X is satisfied and the variable X satisfies: X=P'/4, as shown in FIG. 3.

If the first fiber 41 is large, the inequalities: P'/2-W-X<P'-F, X-W<P'-F, and P'+W-X>F are satisfied, which means P' satisfies: 4(F-W)<P'<2(F-W), enabling the signal trace 47 to be partially superposing the first fibers 41 and partially superposing gaps between two adjacent first fibers 41. A shortest distance between the upper edge of the line segment C1 and the lower edge of the line segment C2 is P'/2-W. A shortest distance between the lower edge of the line segment C1 and the upper edge of the line segment C2 is P'/2+W. If P' satisfies: 2(F-W)<P'<2(F+W), namely P'/2-W<F, and P'/2+W>F, the line segments C1, C2 partially superpose the fibers 41 and partially superpose gaps between two adjacent first fibers 41.

In other words, when P' satisfies: 4(F-W)/3<P'<4(F+W), the signal traces 47 partially superpose the fibers 41 and partially superpose gap between adjacent first fibers 41. As a result, there is little variance between the impedances of the two signal traces 47 and delay time of signals on the two signal traces 47 is minimized, thus ensuring signal transmission quality.

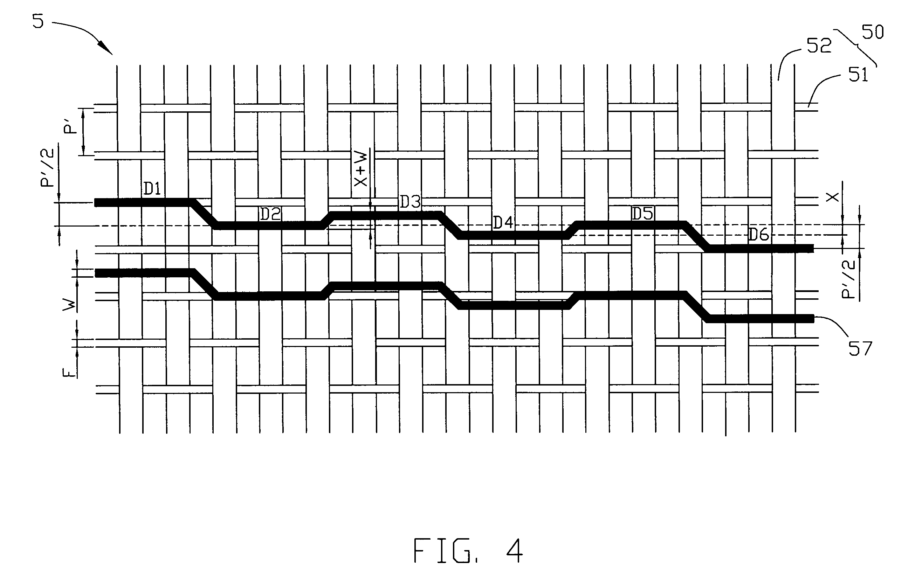

Referring to FIG. 4, a third exemplary embodiment of a PCB 5 includes a base 50 comprising a plurality of parallel first fibers 51 and a plurality of parallel second fibers 52 perpendicular to the plurality of first fibers 51. Two signal trace 57 are formed on the PCB 5. Each signal traces 57 includes a plurality of parallel line segments D1, D2, D3, D4, D5, and D6 connected end to end by diagonal line segments oriented at an angle of 45. or -45 degrees from the plurality of parallel line segments. A shortest distance between the centerlines of two adjacent first fibers 41 is P'. A width of the first fiber 51 is F. A width of the signal trace 57 is W. A shortest distance between the centerlines of the line segments D1, D2 is substantially equal to P'/2. A shortest distance between centerlines of the line segments D2, D3 is X. A shortest distance between centerlines of the line segments D4, D3 is 2X. The shortest distance between centerlines of the line segments D5, D4 is X. A shortest distance between centerlines of the line segments D6, D5 is P'/2. The line segments D1, D3 are on one side of the line segment D2. The line segments D4, D6 are on the same side of the line segment D5. A length of the line segment D1 is substantially equal to a length of the line segment D2. A length of the line segment D4 is substantially equal to a length of the line segment D3. A length of the line segment D6 is substantially equal to a length of the line segment D5. The shortest distance between an upper edge of the line segment D3 and a lower edge of line segment D1 is P'/2-W-X, and substantially equal to a shortest distance between an upper edge of the line segment D6 and a lower edge of line segment D4. A shortest distance between a lower edge of the line segment D3 and an upper edge of one of the line segments D2, D5, and a shortest distance between a lower edge of the line segment D5 and an upper edge of the line segment D4 are both substantially equal to X-W.

If the first fiber 51 is thin, the inequalities: P'/2-W-X<F, X-W<F are satisfied, which means P' satisfies: 2(W+F)<P'<4(F+W), enabling the signal trace 57 to be partially superposing the first fibers 51 and partially superposing gaps between two adjacent first fibers 51. If the first fiber 51 is large, the inequalities: P'/2-W-X<P'-F, X-W<P'-F are satisfied, which means P' satisfies: 4(F-W)<P'<2(F-W), enabling the signal trace 57 to be partially superposing the first fibers 51 and partially superposing gaps between two adjacent first fibers 51. A shortest distance between the upper edge of the line segment D1 and the lower edge of the line segment D2 is P'/2+W. A shortest distance between the lower edge of the line segment D1 and the upper edge of the line segment D2 is P'/2-W. If P' satisfies: 2(F-W)<P'<2(F+W), namely P'/2-W<F, and P'/2+W>F, the line segments D1, D2 partially superpose the first fibers 51 and partially superpose gaps between two adjacent first fibers 51.

In other words, when P' satisfies: 4(F-W)/3<P'<4(F+W), the signal traces 57 partially superpose the first fibers 51 and partially superposes gap between adjacent first fibers 51. As a result, there is little variance between the impedances of the two signal traces 57 and delay time of signals on the two signal traces 57 is minimized, thus ensuring signal transmission quality.

It is to be understood, however, that even though numerous characteristics and advantages of the embodiments have been set forth in the foregoing description, together with details of the structure and function of the embodiments, the disclosure is illustrative only, and changes may be made in detail, especially in matters of shape, size, and arrangement of parts within the principles of the embodiments to the full extent indicated by the broad general meaning of the terms in which the appended claims are expressed.

## Claims

1. A printed circuit board, comprising:
a base comprising a plurality of parallel first fibers and a plurality of parallel lengthways fibers substantially perpendicular to the plurality of parallel first fibers; and
a signal trace comprising a plurality of straight line segments parallel to the first fibers, wherein the signal trace is formed on the base such that the line segments of the signal trace mapped on the base partially superpose the first fibers and partially superpose gap between adjacent first fibers.

2. The printed circuit board of claim 1, wherein each of the line segments comprises a first line segment, a second line segment, a third line segment, and a fourth line segment;
the first line segment and the third line segment are on one side of the second line segment;
a shortest distance between the centerlines of two adjacent first fibers is P, a width of the first fiber is F, and a width of the signal trace is W;
a shortest distance between the centerlines of the first line segment and the second line segment is P/2;
a shortest distance between the centerlines of the second line segment and the third line segment is X;
a shortest distance between the centerlines of the fourth line segment and the third line segment is P/2;
upon the condition that P satisfies: 2(W+F)<P<4(W+F), then X satisfies: P/2-W-F<X<P-F+W;
upon the condition that P satisfies: 4(F-W)/3<P<2(F-W), then X satisfies: F-P/2-W<X<P-F+W.

3. The printed circuit board of claim 2, further comprising a connecting line segment connected between two adjacent line segments.

4. The printed circuit board of claim 1, wherein each of the line segments further comprises a first line segment, a second line segment, a third line segment, a fourth line segment, a fifth line segment, and a sixth line segment;
the first line segment and the third line segment are on one side of the second line segment;
a shortest distance between the centerlines of two adjacent first fibers is P, a width of the first fiber is F, and a width of the signal trace is W;
a shortest distance between projections of the centerlines of the first line segment and the second line segment is P/2;
a shortest distance between projections of the centerlines of the second line segment and the third line segment is X;
a shortest distance between projections of the centerlines of the fourth line segment and the fifth line segment is X;
a shortest distance between projections of the centerlines of the fifth line segment and the sixth line segment is P/2;
the fourth line segment and the sixth line segment are on the same side of the fifth line segment;
upon the condition that P satisfies: 2(W+F)<P<4(W+F), then X satisfies: P/2-W-F<X<P-F+W;
upon the condition that P satisfies: 4(F-W)/3<P<2(F-W), then X satisfies: F-P/2-W<X<P-F+W.

5. The printed circuit board of claim 1, wherein a shortest distance between centerlines of two adjacent first fibers is P; a shortest distance between projections of the centerlines of two adjacent line segments is N*P/2; N is an odd number.

6. The printed circuit board of claim 5, wherein a total length of a portion of the line segments which superpose the first fibers is substantially equal to a total length of a portion of the line segments which superposes gaps between each two adjacent first fibers.

7. The printed circuit board as claimed in any of claims 1 to 6 , wherein a length of each line segment is substantially equal to a length of at least one adjacent line segment.

8. A method for producing a printed circuit board, the method comprising:
providing a base, the base comprises a set of parallel first fibers and a set of parallel second fibers, the first fibers and the second fibers interlacing with each other; and
forming a signal trace, the signal trace having a plurality of straight line segments on the base such that the line segments of the signal trace formed on the base partially superpose the first fibers and partially superpose gaps between two adjacent first fibers.

9. The method of claim 8, wherein the line segments comprise a first line segment, a second line segment, a third line segment, and a fourth line segment;
the first line segment and the third line segment are on one side of the second line segment;
a shortest distance between centerlines of two adjacent first fibers is P, a width of the first fiber is F, and a width of the signal trace is W;
a shortest distance between projections of the centerlines of the first line segment and the second line segment is P/2;
a shortest distance between projections of the centerlines of the second line segment and the third line segment is X;
a shortest distance between projections of the centerlines of the forth line segment and the third line segment is P/2;
upon the condition that P satisfies: 2(W+F)<P<4(W+F), then X satisfies: P/2-W-F<X<P-F+W;
upon the condition that P satisfies: 4(F-W)/3<P<2(F-W), then X satisfies: F-P/2-W<X<P-F+W.

10. The method of claim 9, wherein a connecting line segment is connected between two adjacent line segments.

11. The method of claim 8, wherein the line segments comprise a first line segment, a second line segment, a third line segment, a fourth line segment, a fifth line segment, and a sixth line segment;
the first line segment and the third line segment being on the same side of the second line segment;
a shortest distance between centerlines of two adjacent first fibers is P, a width of the first fiber is F, and a width of the signal trace is W;
a shortest distance between projections of the centerlines of the first line segment and the second line segment being P/2;
a variable X defined as a shortest distance between projections of the centerlines of the second line segment and the third line segment;
a shortest distance between projections of the centerlines of the fourth line segment and the fifth line segment is X, a shortest distance between projections of the centerlines of the fifth line segment and the sixth line segment is P/2;
the forth line segment and the sixth line segment being on the same side of the fifth line segment;
upon the condition that P satisfies: 2(W+F)<P<4(W+F), then X satisfies: P/2-W-F<X<P-F+W;
upon the condition that P satisfies: 4(F-W)/3<P<2(F-W), then X satisfies: F-P/2-W<X<P-F+W.

12. The method of claim 8, wherein a shortest distance between centerlines of two adjacent first fibers is P; a shortest distance between projections of the centerlines of two adjacent line segments is N*P/2; N is an odd number.

13. The method of claim 12, wherein a total length of the line segments which superpose the first fibers is substantially equal to a total length of the line segments which superpose gaps between each two adjacent first fibers.

14. The method as claimed in any of claims 8 to 13, wherein a length of each line segment is substantially equal to a length of at least one adjacent line segments.
